(19) Europäisches Patentamt / European Patent Office / Office européen des brevets

(11) **EP 4 439 982 A1**

(12) **EUROPÄISCHE PATENTANMELDUNG**

(43) Veröffentlichungstag:
02.10.2024 Patentblatt 2024/40

(21) Anmeldenummer: 24165743.6

(22) Anmeldetag: 25.03.2024

(51) Internationale Patentklassifikation (IPC):
*H03K 17/95* (2006.01)

(52) Gemeinsame Patentklassifikation (CPC):
**H03K 17/9545; H03K 17/9502;** H03K 2017/9527

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: 28.03.2023 DE 102023107760

(71) Anmelder: **Turck Holding GmbH**
**58553 Halver (DE)**

(72) Erfinder: **Wendler, Torsten**
**08340 Schwarzenberg (DE)**

(74) Vertreter: **DTS Patent- und Rechtsanwälte PartmbB**
**Brienner Straße 1**
**80333 München (DE)**

(54) **INDUKTIVER NÄHERUNGSSCHALTER UND VERFAHREN ZUM BETREIBEN EINES INDUKTIVEN NÄHERUNGSSCHALTERS**

(57) Die vorliegende Erfindung betrifft einen induktiven Näherungsschalter (100), umfassend einen Signal-Schwingkreis und einen Referenz-Schwingkreis; eine Multiplexer-Schaltung (106) zum wechselweisen Aktivieren des Signal-Schwingkreises oder des Referenzschwingkreises; eine Treiberschaltung (108) mit einem Oszillator zum Betreiben des aktivierten Signal-Schwingkreises oder Referenz-Schwingkreises mit einer Oszillatorfrequenz; ein Erfassungsmodul (112) zum Erfassen eines Schwingungsparameters des aktivierten Signal-Schwingkreises oder Referenz-Schwingkreises; und ein Auswertungsmodul (118), das dazu eingerichtet ist, anhand des Schwingungsparameters für den aktivierten Signal-Schwingkreis und des Schwingungsparameters für den aktivierten Referenz-Schwingkreis ein Differenzsignal zu bestimmen sowie in Abhängigkeit von dem Differenzsignal ein Steuerungssignal zu erzeugen. Dabei ist der Signal-Schwingkreis so ausgebildet, dass der Schwingungsparameter von einer Position eines Targets (128) in einen Erfassungsbereich (126) abhängt; und der Referenz-Schwingkreis ist so ausgebildet, dass der Schwingungsparameter im Wesentlichen unabhängig ist von der Position des Targets (128) im Erfassungsbereich (126).

Fig. 1A

Fig. 1B

EP 4 439 982 A1

**Beschreibung**

Die vorliegende Erfindung betrifft einen induktiven Näherungsschalter und ein Verfahren zum Betreiben eines induktiven Näherungsschalters.

Aus dem Stand der Technik sind induktive Näherungsschalter bekannt. Um das Eindringen eines Target in einen Erfassungsbereich zu detektieren, wird ein hochfrequentes elektromagnetisches Feld erzeugt und der Einfluss des Targets auf dieses Feld bestimmt.

Die Veränderung des Feldes kann von verschiedenen Faktoren abhängen, etwa von der Position des Targets in dem Erfassungsbereich, von den elektrischen und magnetischen Materialeigenschaften des Targets sowie von der Masse des Targets im Erfassungsbereich.

Bei einem bestimmten Target kann anhand der Veränderung des Feldes auf eine bestimmte Position des Targets geschlossen werden, insbesondere auf einen bestimmten Abstand von einem definierten Ausgangspunkt, etwa von der Spule eines Schwingkreises zum Erzeugen des elektromagnetischen Feldes.

Verschiedene Umgebungsparameter können einen erheblichen Einfluss auf die Messung und die Funktion des Näherungsschalters haben. Insbesondere verändern sich die Schwingungseigenschaften von Schwingkreisen und die elektrischen Eigenschaften der verwendeten Bauteile. Gerade bei hohen Schaltabständen kann die Änderung des Nutzsignals bei einer Annäherung des Targets in der Größenordnung der durch Temperaturänderung hervorgerufenen Effekte liegen. Zur Kompensation dieser Effekte wurden verschiedene Methoden vorgeschlagen.

In der DE 10 2005 001 692 A1 wird vorgeschlagen, einen steuerbaren Oszillatorverstärker und einen Temperaturfühler vorzusehen, sodass temperaturbedingte Variationen der Oszillator-Eigenschaften kompensiert werden können.

Bei dem Verfahren der DE 3 527 650 A1 ist eine temperaturabhängige Stromquelle vorgesehen, um die Temperaturtrift eines Transistors einer Verstärkerstufe auszugleichen und die Wechselstromverstärkung der Schaltungsanordnung konstant zu halten.

Aus der DE 10 2017 128 472 A1 ist ein induktiver Näherungsschalter bekannt, bei dem die Induktivität einer Schwingkreisspule gemessen wird und entsprechend Einstellungen zur Temperaturkompensation ausgeführt werden.

Die DE 10 2013 202 573 B3 schlägt vor, die Messung des Kupferwiderstands der Oszillatorspule zur Temperaturmessung zu nutzen und anhand dieses Messwertes eine Schaltschwelle zu korrigieren. Dadurch wird der Schaltabstand des Näherungsschalters gegenüber Temperaturschwankungen stabilisiert.

In der US 2010/0225332 A1 erfolgt die Temperaturkompensation anhand einer Schaltung zur Temperaturmessung und einer nachgeschalteten Signalverarbeitungsschaltung.

Den bekannten Lösungen ist gemeinsam, dass sie einen oft erheblichen zusätzlichen Schaltungsaufwand bedeuten.

Es ist die Aufgabe der vorliegenden Erfindung, einen induktiven Näherungssensor bereitzustellen, bei dem die Einflüsse von Umgebungsparametern wie der Temperatur einfach und mit möglichst geringem Aufwand kompensiert werden können.

Diese Aufgabe wird erfindungsgemäß gelöst durch einen Näherungsschalter und ein Verfahren zum Betreiben eines Näherungsschalters mit den Merkmalen der unabhängigen Ansprüche. Vorteilhafte Ausgestaltungen sind in den Unteransprüchen angegeben.

Danach wird die Aufgabe gelöst durch einen induktiven Näherungsschalter, umfassend einen Signal-Schwingkreis und einen Referenz-Schwingkreis sowie eine Multiplexer-Schaltung zum wechselweisen Aktivieren des Signal-Schwingkreises oder des Referenzschwingkreises. Der Näherungsschalter umfasst ferner eine Treiberschaltung mit einem Oszillator zum Betreiben des aktivierten Signal-Schwingkreises oder Referenz-Schwingkreises mit einer Oszillatorfrequenz, ein Erfassungsmodul zum Erfassen eines Schwingungsparameters des aktivierten Signal-Schwingkreises oder Referenz-Schwingkreises sowie ein Auswertungsmodul, das dazu eingerichtet ist, anhand des Schwingungsparameters für den aktivierten Signal-Schwingkreis und des Schwingungsparameters für den aktivierten Referenz-Schwingkreis ein Differenzsignal zu bestimmen und in Abhängigkeit von dem Differenzsignal ein Steuerungssignal zu erzeugen. Dabei ist der Signal-Schwingkreis so ausgebildet, dass der Schwingungsparameter von einer Position eines Targets in einen Erfassungsbereich abhängt. Ferner ist der Referenz-Schwingkreis so ausgebildet, dass der Schwingungsparameter im Wesentlichen unabhängig ist von der Position des Targets im Erfassungsbereich.

Insbesondere wird das erzeugte Schaltsignal ausgegeben und etwa an einer Steuereinheit übertragen, die dann eine Steuerung in Abhängigkeit von dem Schaltsignal durchführt.

Die Erfindung basiert unter anderem auf der Erkenntnis, dass mit das Differenzprinzip eine besonders einfache und robust anwendbare Kompensation von Störeinflüssen erlaubt.

Insbesondere ist das Target beziehungsweise Zielobjekt ein Objekt, das zumindest teilweise aus Metall gebildet ist oder ein metallisches Element umfasst. Ein solches Objekt kann dadurch, dass es das elektromagnetische Feld des Signal-Schwingkreises beeinflusst, mittels der induktiven Näherungsdetektion erfasst werden.

Die Abhängigkeit des Schwingungsparameters des Signal-Schwingkreises von der "Position" des Targets im Erfassungsbereich wird so verstanden, dass sich der Schwingungsparameter des Signal-Schwingkreises unterscheidet je nachdem, ob sich das Target sich im Erfassungsbereich befindet oder nicht. Ferner kann der Schwingungsparameter nicht nur von der Präsenz des Targets im Erfassungsbereich, sondern von seinem Abstand zu einem bestimmten Referenzpunkt, etwa der Position der Signalspule, beeinflusst sein, sodass umgekehrt anhand des Schwingungsparameters der Abstand bestimmbar ist. Zudem kann der Schwingungsparameter des Signal-Schwingkreises von der Position und/oder Lage des Targets im Raum abhängen.

Insbesondere ist anhand des Schwingungsparameters eine Veränderung der Position und/oder Lage des Targets bestimmbar, etwa ein Eindringen des Targets in den Erfassungsbereich oder ein Verlassen desselben.

Bei einer weiteren Ausbildung umfasst der Signal-Schwingkreis eine Signalspule und der Referenz-Schwingkreis eine Referenzspule.

Die Signalspule ist so ausgebildet, dass das in Verbindung mit dem Signal-Schwingkreis erzeugte Magnetfeld der Spule eine viel größere Reichweite aufweist als das Magnetfeld der Referenzspule im Zusammenhang mit dem Referenz-Schwingkreis. Die Reichweite der Sendespule ist dabei abhängig vom Spulendurchmesser und der Anzahl der Windungen und bestimmt damit den Erfassungsbereich des Sensors. Die Referenzspule ist dagegen insbesondere so ausgeführt, dass das sich ergebende Magnetfeld sich selbst auslöscht und somit der Erfassungsbereich minimiert wird. Unter "Reichweite" kann beispielsweise der Feldbereich der Spule verstanden werden, bei dem ein Eintreten eines Targets eine messbare Änderung des Schwingungsparameters bewirkt. Die Reichweite des Signal-Schwingkreises umfasst insbesondere den Erfassungsbereich, während die Reichweite der Referenz-Schwingkreises nicht bis zum Erfassungsbereich reicht.

Insbesondere sind dabei die Signalspule und die Referenzspule mit im Wesentlichen gleicher Induktivität ausgebildet. Der Signal-Schwingkreis und der Referenz-Schwingkreis weisen insbesondere die gleiche Eigenfrequenz auf, soweit sie mit den Spulen und der gleichen Kapazität betrieben werden.

Anders als der Signal-Schwingkreis wird der Referenz-Schwingkreis vom Target in dem Erfassungsbereich praktisch nicht beeinflusst. Allerdings wirken die Umgebungsparameter wie Temperaturänderungen oder elektromagnetische Störungen in gleicher Weise auf die beiden Spulen. Das heißt, eine Messung mittels des Referenz-Schwingkreises erlaubt in erster Linie Aussagen über die Beeinflussung des Schwingungsparameters durch die Umgebungsparameter, unabhängig von der Position des Targets im Erfassungsbereich.

Bei einer weiteren Ausbildung ist die Multiplexer-Schaltung dazu eingerichtet, zum Aktivieren des Signal-Schwingkreises eine Verbindung leitend zu schalten, so dass ein Kondensator und die Signalspule den Signal-Schwingkreis bilden, und zum Aktivieren des Referenz-Schwingkreises eine Verbindung leitend zu schalten, so dass der Kondensator und die Referenz-Spule den Referenz-Schwingkreis bilden. Dabei ist die jeweils andere Verbindung nicht leitend geschaltet.

Dabei wird bevorzugt der gleiche Kondensator für beide Schwingkreise verwendet, nämlich jeweils zusammen mit der Signal- oder der Referenzspule. Dadurch ergeben sich keine unterschiedlichen Schwingungseigenschaften durch verschiedene Kondensatoren im Signal- und Referenz-Schwingkreis.

Bei dem Näherungsschalter wird stets nur einer der beiden Schwingkreise betrieben, da sich beide gleichzeitig stören würden. Die Multiplexer-Schaltung ist insbesondere dazu eingerichtet sicherzustellen, dass die beiden Schwingkreisen abwechselnd und nicht gleichzeitig aktiviert werden.

Bei einer Ausbildung ist ein Operationsverstärker vorgesehen, welcher der Treiberschaltung nachgelagert und dem Erfassungsmodul vorgelagert angeordnet ist. Dieser dient dazu, die Impulse der erfassten Schwingung vor der Erfassung zu verstärken und für das nachfolgende Erfassungsmodul aufzubereiten.

Die Signal- und Referenzspule sind insbesondere als Planarspulen ausgebildet, die beispielsweise durch einen Leiterplattenprozess oder durch Drucken hergestellt werden können.

Bei einer weiteren Ausbildung ist die Signalspule als zylindrisch gewickelte Spule ausgebildet. Hierdurch ist mit der Signalspule in einem Signal-Schwingkreis vorteilhafterweise ein gerichtetes hochfrequentes elektromagnetisches Feld erzeugbar. Die Signalspule ist so ausgebildet, dass mit ihr ein elektromagnetisches Feld so erzeugt werden kann, dass seine Reichweite und somit sein Erfassungsbereich möglichst groß ausgebildet ist und beim Eindringen eines Targetmaterials eine messbare Änderung eines Schwingungsparameters, beispielsweise der Schwingfrequenz, bewirkt.

Bei einer weiteren Ausbildung weist die Referenzspule eine Mehrzahl von Teil-Wicklungen auf, insbesondere vier Teil-Wicklungen oder ganzzahlige Vielfache von vier Teil-Wicklungen, wobei die Teil-Wicklungen zueinander gegenläufig ausgebildet sind. Zumindest ist eine gerade Anzahl von zueinander gegenläufig ausgebildeten Teil-Wicklungen vorgesehen, wobei die Ausbildung mit einem ganzzahligen Vielfachen von vier Teil-Wicklungen durch die zusätzliche Symmetrie eine besonders gute Minimierung des nach außen wirksamen Magnetfeldes bewirkt, insbesondere bei gleicher Induktivität wie dem Signal-Schwingkreis beiehungsweise bei dessen Detektionsspule.

Vier Teil-Wicklungen können als "Quadranten", das heißt in vier im Wesentlichen gleich großen Sektoren, angeordnet sein.

Insbesondere sind jeweils zwei nebeneinander angeordnete Teil-Wicklungen gegenläufig ausgebildet. Durch die gegenläufige Ausbildung fließt der Strom in den Teil-Wicklungen jeweils in umgekehrte Richtung und die induzierten Magnetfelder sind gegenläufig.

Bei einer weiteren Ausbildung sind die gegenläufigen Teil-Wicklungen so ausgebildet und/oder angeordnet, dass sich die von den Teil-Wicklungen erzeugbaren Hochfrequenzfelder bei aktiviertem Referenz-Schwingkreis im Wesentlichen auslöschen. Die gegenläufig ausgebildeten Teil-Wicklungen sind insbesondere so ausgebildet, dass sie eine im Wesentlichen gleiche Induktivität aufweisen. Dadurch löschen sich die durch die Teil-Wicklungen induzierten elektromagnetischen Felder gegenseitig aus.

Insbesondere wird durch die Ausbildung der Referenzspule eine geringe Reichweite des resultierenden Feldes des Referenz-Schwingkreises erzielt. Zum Beispiel beträgt die Reichweite des Referenz-Schwingkreises höchstens 10 %, bevorzugt höchstens 5 %, der Reichweite des Signal-Schwingkreises.

Bei einer weiteren Ausbildung sind die Signalspule und die Referenzspule flach ausgebildet und in Lagen übereinander angeordnet. Die Spulen können insbesondere in übereinander angeordneten Schichten gedruckt werden.

Bei einer weiteren Ausbildung ist zumindest eine Gitterschicht mit der Signalspule und der Referenzspule übereinander angeordnet. Dabei ist insbesondere die Gitterschicht für eine Abschirmung im Sinne der elektromagnetischen Verträglichkeit (EMV) des induktiven Näherungsschalters eingerichtet.

Insbesondere ist die Gitterstruktur dabei nicht geschlossen.

Insbesondere verlaufen die Gitterlinien so, dass sie in einer Projektion die Spulenwindungen der Signalspule beziehungsweise der Referenzspule rechtwinklig schneiden. Dadurch kann eine kapazitive Beeinflussung vermieden werden.

Insbesondere sind zwei Gitterschichten vorgesehen, zwischen denen die Signal- und die Referenzspule angeordnet sind; dabei ist eine erste Gitterschicht oberhalb der Signalspule und der Referenzspule angeordnet und eine zweite Gitterschicht ist unterhalb der Signalspule und der Referenzspule angeordnet. Diese Gitterstruktur ist insbesondere nicht in sich geschlossen und sie ist bevorzugt an die Schaltungsmasse angebunden.

Bei einer weiteren Ausbildung betrifft der Schwingungsparameter eine Frequenz und/oder Amplitude des aktivierten Schwingkreises. Beispielsweise ist die Erfassungseinheit dazu eingerichtet, eine Anzahl von innerhalb einer vorbestimmten Torzeit gemessenen Schwingungen des aktivierten Schwingkreises zu bestimmen. Ferner kann die Frequenz bestimmt werden, insbesondere anhand der gezählten Schwingungen und der vorbestimmten Torzeit.

Es kann also durch die Erfassungseinheit bestimmt werden, wie sich die Frequenz, insbesondere die Eigenfrequenz, als Schwingungsparameter des jeweils aktivierten Signal- beziehungsweise Referenz-Schwingkreises bei Beeinflussung durch das Target im Erfassungsbereich verändert.

Je länger dabei die vorbestimmte Torzeit ist, desto genauer kann die Frequenz des aktivierten Schwingkreises bestimmt werden. Umso besser ist daher die räumliche Auflösung und desto schlechter ist die zeitliche Auflösung bei der Messung. Umgekehrt kann eine verbesserte zeitliche Auflösung durch eine kürzere Torzeit erhalten werden, wobei dann die Frequenz weniger genau bestimmt wird und daher die räumliche Auflösung der Messung weniger genau ist. Dies bedeutet, dass bei einer langen Torzeit die Messung genauer ist, aber das Messergebnis und damit das Ausgangssignal des Sensors längere Zeit später zur Verfügung steht, als bei einer kürzeren Torzeit; auf das Eintreten des Targets in den Erfassungsbereich wird daher später reagiert.

Bei einer Ausbildung wird das Differenzsignal durch das Auswertungsmodul bestimmt, indem anhand der Anzahl der Schwingungen innerhalb der Torzeit bei aktivierter Signal- und Referenzspule eine Differenz gebildet wird. Dies entspricht insbesondere einem Bestimmen der Differenz der Frequenzen von Signal- und Referenzspule.

Das so bestimmte Differenzsignal kann daher als kompensiertes Messsignal betrachtet werden. Da die Umgebungsparameter wie etwa die Temperatur die Signalspule und die Referenzspule im Wesentlichen auf gleiche Weise betreffen, werden als Differenzsignal nur noch diejenigen Änderungen der Frequenz betrachtet, die durch das Target im Erfassungsbereich des Signal-Schwingkreises bedingt sind.

Bei einer weiteren Ausbildung kann als Schwingungsparameter eine Amplitude des Signals erfasst werden; insbesondere wird dabei eine Dämpfung des Signals durch ein im Erfassungsbereich angeordnetes Target gemessen. Die Bestimmung des Differenzsignals erfolgt dann analog zum oben erläuterten Vorgehen so, dass nur noch derjenige Anteil der Dämpfung ausgewertet wird, der durch die Position des Targets im Erfassungsbereich bedingt ist, ohne den Effekt von Störungen durch Umgebungsparameter. Insbesondere wird dabei ausgenutzt, dass bei Annäherung eines (insbesondere metallischen) Targets dem Schwingkreis Energie entzogen wird und die Amplitude der Signal- beziehungsweise Detektionsspule kleiner wird. Hingegen wird das Magnetfeld der Referenzspule nicht beeinflusst. Die bei der Referenzspule erfasste Amplitude bleibt somit konstant. Es kann daher die Differenz der Amplitudensignale für den Signal und den Referenz-Schwingkreis ausgewertet werden.

Das Auswertungsmodul erzeugt anhand des Differenzsignals ein Steuerungssignal. Beispielsweise kann ein Schwellenwert vorgegeben sein, bei dessen Über- und/oder Unterschreiten ein Schaltsignal ausgelöst wird. Insbesondere entspricht dabei der Schwellenwert einer bestimmten Position des Targets im Erfassungsbereich, etwa einem bestimmten Abstand zu einem Referenzpunkt.

Das Steuerungssignal kann auch eine Ausgabe eines Messwerts für den Schwingungsparameter oder das Differenzsignal umfassen. Anhand des so ausgegebenen Messwerts kann beispielsweise die Position des Targets bestimmbar sein.

Bei dem Verfahren zum Betreiben eines induktiven Näherungsschalters mit einem Signal-Schwingkreis und einem Referenz-Schwingkreis werden ein Signal-Schwingkreis und ein Referenz-Schwingkreis wechselweise aktiviert. Ein Schwingungsparameter wird für den Signal-Schwingkreis und für den Referenz-Schwingkreis erfasst und anhand der erfassten Werte des Schwingungsparameters wird ein Differenzsignal bestimmt. Dabei ist der Signal-Schwingkreis so ausgebildet, dass der Schwingungsparameter von einer Position eines Targets in einen Erfassungsbereich abhängt, und der Referenz-Schwingkreis ist so ausgebildet, dass der Schwingungsparameter im Wesentlichen unabhängig ist von der Position des Targets im Erfassungsbereich.

Das Verfahren ist in erster Linie dazu eingerichtet, den induktiven Näherungsschalter gemäß der vorliegenden Beschreibung zu betreiben. Es weist daher die gleichen Vorteile auf wie der Näherungsschalter.

Weitere Einzelheiten und Vorteile der Erfindung sollen nun anhand eines in den Zeichnungen dargestellten Ausführungsbeispiels näher erläutert werden.

Es zeigen:

| | |
|---|---|
| Fig. 1A | eine schematische Darstellung eines Ausführungsbeispiels des Näherungsschalters; |
| Fig. 1B | ein Beispiel des Verfahrens zum Betreiben des Näherungsschalters; |
| Fig. 2 | ein erstes Abschirmgitter; |
| Fig. 3A und 3B | Vorder- und Rückseite eines Ausführungsbeispiels einer Signalspule; |
| Fig. 4A und 4B | Vorder- und Rückseite eines Ausführungsbeispiels einer Referenzspule; |
| Fig. 5 | ein weiteres Abschirmgitter mit Spulenanschlüssen; |
| Fig. 6A und 6B | Vorder- und Rückseite eines weiteren Ausführungsbeispiels einer Referenzspule; |
| Fig. 7A und 7B | Vorder- und Rückseite eines weiteren Ausführungsbeispiels einer Signalspule; und |
| Fig. 8 | eine schematische Darstellung der elektrischen Ströme und der Magnetfelder in der Referenzspule des weiteren Ausführungsbeispiels. |

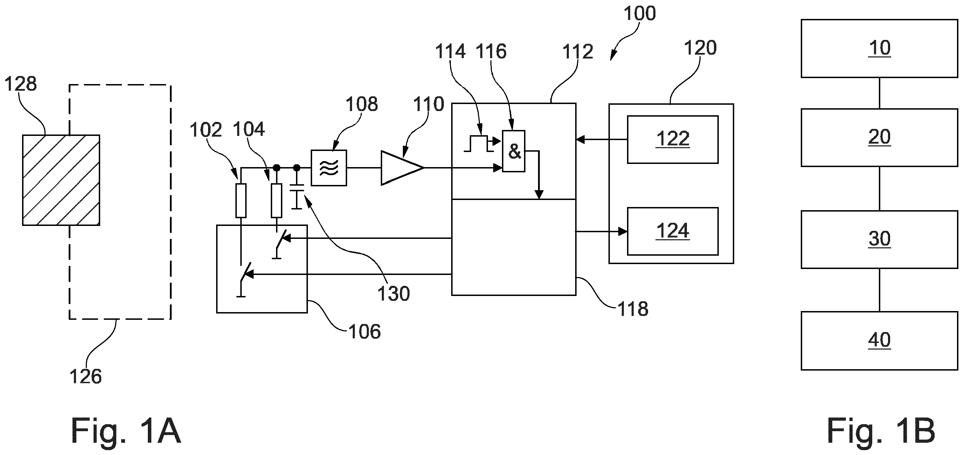

Mit Bezug zu den Fig. 1A und 1B werden eine schematische Darstellung eines Ausführungsbeispiels des Näherungsschalters sowie ein Verfahren zu dessen Betrieb erläutert.

Der induktive Näherungsschalter 100 umfasst eine Signalspule 102 und eine Referenzspule 104. Bei diesem Beispiel sind die beiden Spulen 102, 104 mit einer im Wesentlichen gleichen Induktivität ausgebildet.

Die Signalspule 102 ist so ausgebildet, dass ein mit ihr in einem Signal-Schwingkreis erzeugtes elektromagnetisches Feld eine Reichweite aufweist, die zumindest einen Erfassungsbereich 126 umfasst. Wenn ein Target 128, insbesondere aus einem metallischen Material, in den Erfassungsbereich 126 eindringt, so verändern sich die Schwingungseigenschaften des Signal-Schwingkreises und anhand der Änderung kann die Position des Targets 128 detektiert werden.

Die Referenzspule 104 ist hingegen so ausgebildet, dass ein mit ihr in einem Referenz-Schwingkreis erzeugtes elektromagnetisches Feld eine deutlich kürzere Reichweite aufweist, die insbesondere nicht bis zum Erfassungsbereich 126 reicht. Ein Target 128 im Erfassungsbereich 126 verändert daher die Schwingungseigenschaften des Referenz-Schwingkreises nicht.

Bei dem Ausführungsbeispiel werden diese Eigenschaften unter anderem durch geeignete Wicklungen der Spulen 102, 104 erhalten.

Die Unterschiede bei der Wicklung der Signalspule 102 und der Referenzspule 104 werden unten näher erläutert.

Die Signalspule 102 und die Referenzspule 104 sind so beieinander angeordnet, dass sie im Wesentlichen den gleichen Umgebungsparametern wie Luft oder externen Feldern ausgesetzt sind.

Der Signalspule 102 und der Referenzspule 104 ist eine Multiplexer-Schaltung 106 vorgeschaltet. Diese ist dazu eingerichtet, immer genau eine Spule 102, 104 zu aktivieren, um eine gegenseitige Beeinflussung von Signalspule 102 und Referenzspule 104 im gleichzeitigen Betrieb auszuschließen.

Es ist ferner ein Kondensator 130 mit einer bestimmten Kapazität vorgesehen, welcher der Signalspule 102 und der Referenzspule 104 nachgeschaltet ist. Je nachdem, welche Spule 102, 104 aktiviert ist, bildet der Kondensator 130 zusammen mit der aktivierten Spule einen Signal-Schwingkreis beziehungsweise einen Referenz-Schwingkreis. Bei weiteren Ausführungsbeispielen kann vorgesehen sein, dass der Signal-Schwingkreis und der Referenz-Schwingkreis mit jeweils eigenen Kondensatoren ausgebildet sind.

Wenn die Signalspule 102 mit dem Kondensator 130 verbunden ist, dann ist damit ein Signal-Schwingkreis aktiviert.

Wenn die Referenzspule 104 mit dem Kondensator 130 verbunden ist, dann ist damit ein Referenz-Schwingkreis aktiviert.

Durch das wechselweise Aktivieren des Signal- beziehungsweise Referenz-Schwingkreises wird sichergestellt, dass es zu keinen gegenseitigen Störungen kommt.

Eine Treiberschaltung 108, insbesondere ein Differenzoszillator 108, ist vorgesehen und dazu eingerichtet, den aktivierten Schwingkreis zu betreiben, wobei bei diesem Beispiel die Signalspule 102 oder Referenzspule 104 mit annähernd identischen Eigenfrequenzen betrieben werden.

Dabei sind bei dem Ausführungsbeispiel die Signalspule 102 und die Referenzspule 104 auf einer Planarleiterplatte als PCB-Spule (*printed circuit board,* PCB) zusammengefasst. Sie werden insbesondere durch ein Druckverfahren hergestellt.

Ein Operationsverstärker 110 oder Komparator ist so angeordnet, dass er die Schwingungen des jeweils aktivierten Schwingkreises an das Erfassungsmodul 112 anpasst.

Die Schwingungen werden bei einem Mikrocontroller 112 als Eingangssignal empfangen. Dort wird ein als Rechtecksignal 114 dargestelltes Signal, welches eine Torzeit definiert, über eine logische UND-Operation 116 mit dem empfangenen Eingangssignal multipliziert.

Die Torzeit definiert ein Zeitintervall, in dem das empfangene Eingangssignal ausgewertet wird.

In einem Auswertungsmodul 118, das als Rechenwerk ausgebildet ist, werden bei dem Ausführungsbeispiel die innerhalb der Torzeit auftretenden Schwingungen beziehungsweise Amplituden gezählt. Hieraus ergibt sich die aktuelle Frequenz des aktivierten Schwingkreises.

Alternativ oder zusätzlich zur Frequenzauswertung kann bei einem weiteren Ausführungsbeispiel eine Auswertung über die Amplitude bei kleineren Schwingfrequenzen erfolgen. Bei Annäherung eines (insbesondere metallischen) Targets wird dem Schwingkreis Energie entzogen und die Amplitude der Signalbeziehungsweise Detektionsspule wird kleiner. Dies gilt für die Referenzspule nicht, da das Magnetfeld nicht vom Target beeinflusst wird. Die bei der Referenzspule erfasste Amplitude bleibt somit konstant. Daher kann aus der Differenz beider Amplitudensignale auch ein auswertbarer Messwert erzeugt werden.

Der bei der Auswertung bestimmte Wert wird gespeichert.

Bei dem Ausführungsbeispiel sind das Erfassungsmodul 112 und das Auswertungsmodul 118 in einem gemeinsamen Mikrocontroller integriert. Dieser wird über einen Spannungsregler 122 versorgt. Die Ausgabe des Schaltsignals geschieht über einen Ausgangstreiber 124. Der Spannungsregler 122 und der Ausgangstreiber 124 sind in eine Steuereinheit 120 integriert, die mit dem Mikrocontroller verbunden ist.

Bei dem Verfahren wird zunächst in einem Schritt 10 eine der beiden Spulen 102, 104 und damit der entsprechende Schwingkreis aktiviert. Beispielsweise wird zunächst die Signalspule 102 aktiviert, die mit dem Kondensator 130 einen Signal-Schwingkreis bildet.

Der aktivierte Signal-Schwingkreis wird zumindest so lange betrieben, bis bei dem Erfassungsmodul 112 über das Intervall der Torzeit 114 Eingangssignale der Schwingungen erfasst worden sind. Das Auswertungsmodul 118 zählt die Schwingungen innerhalb der Torzeit und speichert diesen ersten Wert.

Anschließend in einem Schritt 20 wird der andere Schwingkreis aktiviert, im beispielhaften Fall also der Referenz-Schwingkreis mit der Referenzspule 104. Dieser wird zumindest so lange betrieben, bis bei dem Erfassungsmodul 112 über das Intervall der Torzeit 114 Eingangssignale der Schwingungen erfasst worden sind. Das Auswertungsmodul 120 zählt die Schwingungen innerhalb der Torzeit und speichert auch diesen zweiten Wert.

In einem Schritt 30 wird bei dem Auswertungsmodul 120 anhand des ersten und des zweiten Werts ein Differenzsignal bestimmt. Dieses Differenzsignal ist im vorliegenden Beispiel eine Differenz des ersten und zweiten Werts. Es gibt daher ein Maß für den Unterschied zwischen der Frequenz des Signal-Schwingkreises und der Frequenz des Referenz-Schwingkreises an.

Anhand des Differenzsignals wird in einem Schritt 40 ein Vergleich mit einem vorgegeben Schwellenwert ausgeführt. Wenn die Differenz des ersten und des zweiten Werts den Schwellenwert überschreitet, dann wird ein Steuersignal ausgegeben. Der vorgegebene Schwellenwert entspricht insbesondere einer Differenz zwischen dem ersten und zweiten Wert, das heißt einer Differenz der Frequenzen von Signal- und Referenz-Schwingkreis, bei der von einer Anwesenheit des Targets 128 im Erfassungsbereich 126 ausgegangen wird.

Ferner kann der Schwellenwert so gebildet sein, dass er einer bestimmten Distanz zwischen einer Referenzposition wie etwa der Position der Signalspule 102 und dem Target 128 entspricht.

Beim Unter- oder Überschreiten des vorgegebenen Schwellenwerts kann das ausgegebene Steuersignal eine Information darüber umfassen, ob das Target 128 den Erfassungsbereich 126 verlässt oder in ihn eintritt. Hierzu kann insbesondere eine zeitliche Veränderung des Differenzsignals bei aufeinanderfolgenden Messungen berücksichtigt werden.

Das Steuersignal kann ferner einen Messwert umfassen, etwa das Differenzsignal oder einen Wert der ober erläuterten Differenz zwischen dem ersten und dem zweiten Wert. Der Messwert kann ferner einem Maß für den Abstand des Targets 128 zur Signalspule 102 oder den Wert des Abstands selbst umfassen. In diesem Fall kann der Näherungsschalter nicht nur zum binären Schalten in Abhängigkeit von der Position des Targets 128 genutzt werden, sondern der detektierte Abstand kann ausgewertet werden.

Beim vorliegenden Beispiel des Verfahrens ist die Frequenz der Schwingkreise der Schwingungsparameter der beiden Schwingkreise, der zur Auswertung verwendet wird. Die Frequenz verändert sich unter dem Einfluss der Umgebungsparameter wie Temperatur sowie beim Signalschwingkreis durch die Position des Targets 128 im Erfassungsbereich 126.

Der Schwingungsparameter der Signalspule 102 hängt von Umgebungseinflüssen wie der Temperatur sowie von der Targetposition ab. Bei der Referenzspule 104 werden hingegen nur Umgebungseinflüsse erfasst, da sie von der Targetposition praktisch nicht beeinflusst wird. Die Frequenzen der wechselweise aktivierten Spulen 102, 104 beziehungsweise der dazugehörigen Schwingkreise werden über eine feste Torzeit im Mikrocontroller 112 und bei dem Erfassungsmodul 118 durch Zählen der einlaufenden Impulse erfasst. Nach einer Differenzbildung beider Signale wird das so entstandene Messsignal mit einem eingelernten Schaltpunkt verglichen. Der eingelernte Schaltpunkt entspricht einem Differenzsignal, das gemessen wird, wenn sich das Target 128 in einer Schaltabstandsposition relativ zur Signalspule 102 beziehungsweise in dem Erfassungsbereich 126 befindet. Bei Erreichen des Schaltpunktes wird das Ausgangssignal des Näherungsschalters aktualisiert.

Der Signalhub ist dabei abhängig von der Entfernung des Targets und von der Länge der Torzeit. Das bedeutet, dass bei einer großen Torzeit eine große Empfindlichkeit des Näherungsschalters erhalten wird und die Detektion mit einer großen Reichweite ausgeführt werden kann; allerdings ist dann die Schaltfrequenz des Sensors klein.

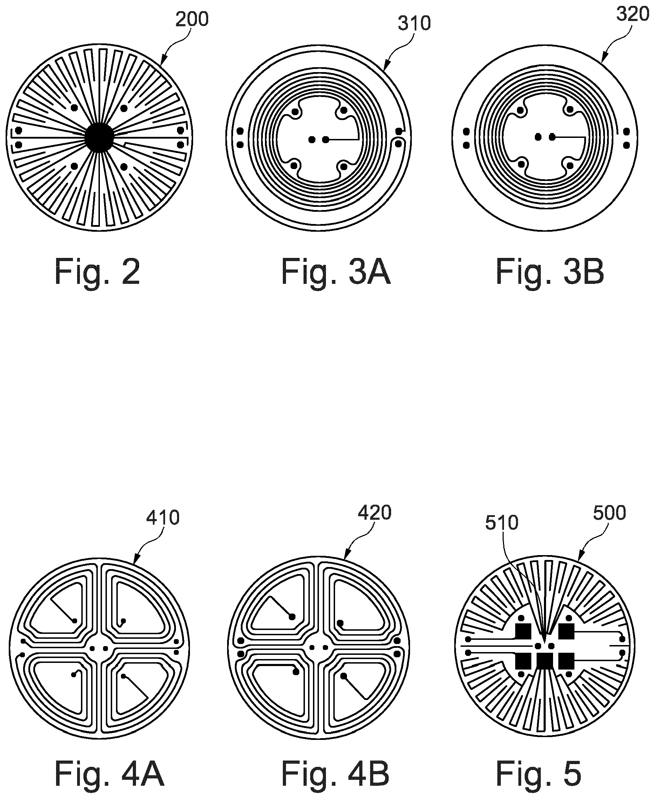

Mit Bezug zu den Fig. 2 bis 5 wird ein Ausführungsbeispiel des Aufbaus einer Spulenanordnung des Näherungsschalters erläutert. Die gezeigten Spulen sind als sechslagige Planarspulen ausgebildet und übereinander angeordnet. Die Herstellung kann insbesondere durch ein Druckverfahren erfolgen.

Als oberer und unterer Abschluss der Spulenanordnung sind das in Fig. 2 gezeigte Abschirmgitter 200 beziehungsweise das in Fig. 5 gezeigte Abschirmgitter 500 mit Anschlüssen für die dazwischen angeordneten Spulen 300, 400 vorgesehen. Für die Abschirmgitter ist ferner vorgesehen, dass diese an die Schaltungsmasse angeschlossen werden, wobei ein Anschluss 510 in Fig. 5 angedeutet ist. Dadurch wird ein gutes EMV-Verhalten der Spulenanordnung erreicht.

In Fig. 3A ist eine Vorderseite 310 der Signalspule in einer Draufsicht von oben gezeigt, in Fig. 3B ist eine Rückseite der Signalspule im Durchblick von unten gezeigt.

In Fig. 4A ist eine Vorderseite 410 der Referenzspule in einer Draufsicht von oben gezeigt, in Fig. 4B ist eine Rückseite der Referenzspule im Durchblick von unten gezeigt.

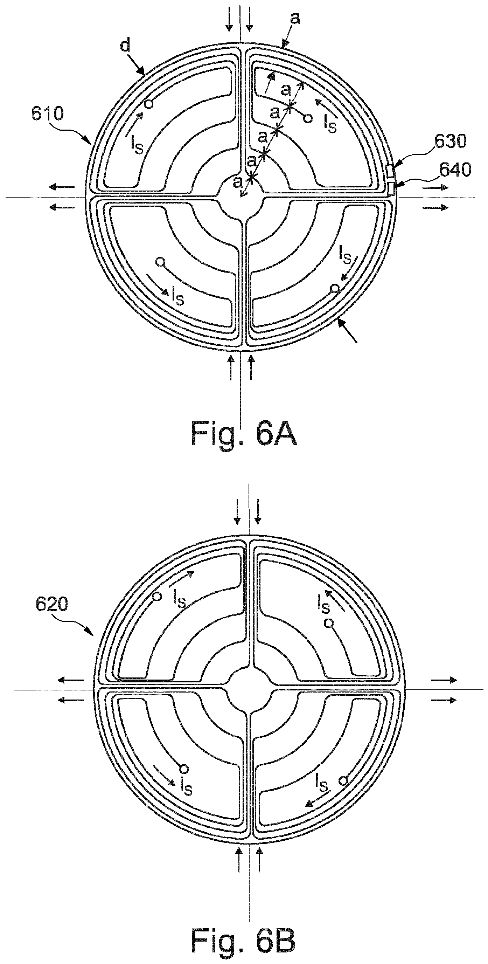

Mit Bezug zu Fig. 6A und 6B wird die Wicklung eines Ausführungsbeispiels der Referenzspule erläutert.

Die gesamte Wicklung weist eine im Wesentlichen kreisrunde Form mit einem Durchmesser d auf, beziehungsweise sie ist auf einer Platine mit dem Durchmesser d angeordnet. Innerhalb dieser Form sind vier Quadranten ausgebildet, wobei die Wicklungen benachbarter Quadranten jeweils zueinander gegenläufig ausgebildet sind.

Es sind ein Spuleneingang 630 und ein Spulenausgang 640 für die elektrischen Anschlüsse der Referenzspule vorgesehen.

Die Wicklungen weisen im inneren Bereich konzentrische Abschnitte auf, welche in einem Abstand a voneinander angeordnet sind. Dabei beträgt bei dem Beispiel der Abstand a ein Zwölftel des Durchmessers d der Platine:

$$a = \frac{d}{12}$$

Pfeile geben die jeweilige Stromrichtung an, die auch mit dem Referenzzeichen Is bezeichnet ist. Dabei ist anhand der Pfeilrichtungen angedeutet, dass die Ströme in den Wicklungen der jeweils benachbarten Quadranten gegenläufig verlaufen, insbesondere gegenläufig in tangentialer Richtung.

Bei weiteren Ausführungsbeispielen kann die Referenzspule statt mit vier Quadranten mit einer anderen Anzahl von Sektoren gebildet sein, wobei diese Anzahl eine gerade Zahl ist, bevorzugt ein ganzzahliges Vielfaches von 4.

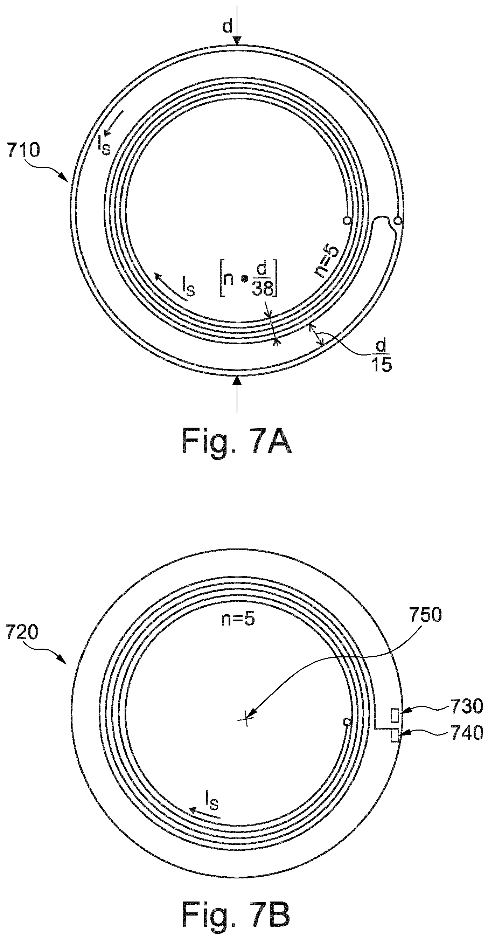

Mit Bezug zu Fig. 7A und 7B wird die Wicklung eines Ausführungsbeispiels der Signalspule erläutert.

Die gesamte Wicklung weist eine im Wesentlichen kreisrunde Form mit einem Durchmesser d auf, beziehungsweise sie ist auf einer Platine mit dem Durchmesser d angeordnet.

Die Wicklung ist als klassische zylindrische beziehungsweise konzentrische Wicklung ausgebildet.

Es sind ein Spuleneingang 730 und ein Spulenausgang 740 für die elektrischen Anschlüsse der Signalspule vorgesehen.

Ferner ist der geometrische Mittelpunkt 750 der gezeigten beispielhaften Wicklung angedeutet.

Bei dem Beispiel weist die Wicklung einen umlaufend ausgebildeten Abschnitt auf sowie n = 5 innere Wicklungen. Der Abstand zwischen dem umlaufenden Abschnitt und den inneren Wicklungen beträgt $\frac{d}{15}$ und die Abstände zwischen den inneren Wicklungen betragen bei dem Beispiel $\frac{d}{38}$, sodass sich bei einer Windungszahl von $n$ eine Breite der inneren Wicklungen von $n\frac{d}{38}$ ergibt.

Auch hier geben mit dem Referenzzeichen Is bezeichnete Pfeile die jeweilige Stromrichtung an.

Dabei ist anhand der Pfeilrichtungen angedeutet, dass der Strom im äußeren Bereich gegenläufig zu den inneren Wicklungen verläuft.

Diese Wicklung erlaubt es, mit der Signalspule in einem Signal-Schwingkreis ein gerichtetes elektromagnetisches Feld zu erzeugen.

Die Induktivitäten der Signalspule und der Referenzspule sollten ungefähr gleich groß sein.

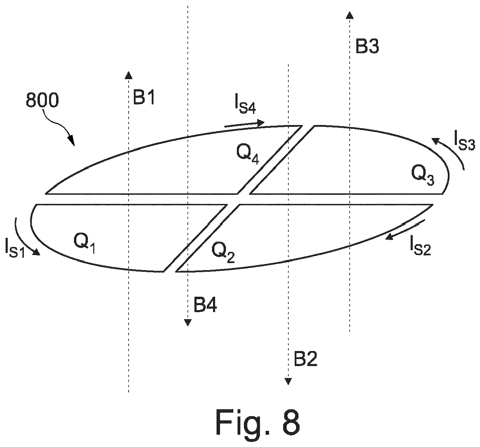

Mit Bezug zu Fig. 8 wird die Funktionsweise der Windungsanordnung der Referenzspule 800 näher erläutert. Dabei wird insbesondere auf die oben mit Bezug zu den Fig. 6A und 6B erläuterte Referenzspule hingewiesen.

Durch den gegensinnigen Wicklungssinn der zueinander benachbarten Quadranten Q1 bis Q4 sind die Stromrichtungen $I_{S1}$ bis $I_{S4}$ in tangentialer Richtung einander entgegengesetzt. Die jeweils entstehenden Magnetfelder B1 bis B4 in den Quadranten Q1 bis Q4 heben sich daher in ihrer Wirkung nach außen hin auf.

Die Referenzspule hat daher eine sehr kurze Reichweite und sie reagiert kaum auf eine Targetannäherung.

Die Differenz Messwerte für die Signalspule und die Referenzspule beziehungsweise die zugeordneten Schwingkreise bildet daher das eigentliche Messsignal, welches unabhängig von externen Störgrößen ist, da diese in gleicher Weise auf beide Spulen wirken und daher durch die Differenzbildung kompensiert werden.

Da bei den Ausführungsbeispiel Luftspulen ohne Ferritkern verwendet werden, werden höhere Schwingfrequenzen erreicht und es sind bei allen zu erfassenden Metallen gleiche Schaltabstände möglich (Faktor 1).

Einer der Vorteile des vorliegend beschrieben induktiven Näherungsschalters liegt darin, dass durch die Anwendung des Differenzprinzips nur das durch die Targetannäherung verursachte Signal ausgewertet wird, während Störeinflüsse ausgeblendet werden. Hierdurch ergibt sich eine gute Stabilität gegen Temperaturänderungen und durch elektromagnetische Wellen verursachte Störungen (elektromagnetische Verträglichkeit, "EMV-Störungen").

Der Schaltungs- und Spulenaufbau sind sehr einfach gestaltet, sodass die Herstellung kostengünstig erfolgen kann. Das Design des Näherungsschalters und der Spulen gemäß der vorliegenden Beschreibung erlaubt einen robusten Aufbau und dadurch auch geringere Rücklaufquoten in der Fertigung. Ferner werden geringere Anforderungen an die Toleranzen bei der Fertigung gestellt als bei alternativen Verfahren.

Der Näherungssensor kann mit geringem Hardwareaufwand und daher vorteilhafterweise günstig hergestellt werden.

**Bezugszeichenliste**

| | |
|---|---|
| 10, 20, 30, 40 | Schritt |
| 100 | Näherungsschalter |
| 102 | Signalspule |
| 104 | Referenzspule |
| 106 | Multiplexer-Schaltung |
| 108 | Treiberschaltung, Differenzoszillator |
| 110 | Operationsverstärker |
| 112 | Erfassungsmodul, Mikrocontroller |
| 114 | Rechtecksignal "Torzeit" |
| 116 | Logische UND-Operation |
| 118 | Auswertungsmodul |
| 120 | Steuereinheit |
| 122 | Spannungsregler |
| 124 | Ausgangstreiber |
| 126 | Erfassungsbereich |
| 128 | Target |
| 130 | Kondensator |
| 200 | Abschirmgitter |
| 310 | Signalspule (Vorderseite) |
| 320 | Signalspule (Rückseite) |
| 410 | Referenzspule (Vorderseite) |
| 420 | Referenzspule (Rückseite) |
| 500 | Gitter mit Spulenanschlüssen |

| 510 | Anschluss |
|-----|-----------|
| 610 | Referenzspule (Vorderseite) |
| 620 | Referenzspule (Rückseite) |
| 630 | Spuleneingang (Referenzspule) |
| 640 | Spulenausgang (Referenzspule) |
| 710 | Signalspule (Vorderseite) |
| 720 | Signalspule (Rückseite) |
| 730 | Spuleneingang (Signalspule) |
| 740 | Spulenausgang (Signalspule) |
| 750 | Mittelpunkt |
| 800 | Referenzspule |

| a | Abstand |
|---|---------|
| B1, B2, B3, B4 | Magnetfeld (Richtung) |
| d | Durchmesser |
| $I_S$, $I_{S1}$, $I_{S2}$, $I_{S3}$, $I_{S4}$ | Strom (Richtung) |
| n | Anzahl, Windungszahl |
| Q1, Q2, Q3, Q4 | Teil-Wicklung , Quadrant |

**Patentansprüche**

1. Induktiver Näherungsschalter (100), umfassend

   - einen Signal-Schwingkreis und einen Referenz-Schwingkreis;
   - eine Multiplexer-Schaltung (106) zum wechselweisen Aktivieren des Signal-Schwingkreises oder des Referenzschwingkreises;
   - eine Treiberschaltung (108) mit einem Oszillator zum Betreiben des aktivierten Signal-Schwingkreises oder Referenz-Schwingkreises mit einer Oszillatorfrequenz;
   - ein Erfassungsmodul (112) zum Erfassen eines Schwingungsparameters des aktivierten Signal-Schwingkreises oder Referenz-Schwingkreises; und
   - ein Auswertungsmodul (118), das dazu eingerichtet ist, anhand des Schwingungsparameters für den aktivierten Signal-Schwingkreis und des Schwingungsparameters für den aktivierten Referenz-Schwingkreis ein Differenzsignal zu bestimmen sowie in Abhängigkeit von dem Differenzsignal ein Steuerungssignal zu erzeugen; wobei
   - der Signal-Schwingkreis so ausgebildet ist, dass der Schwingungsparameter für den Signal-Schwingkreis von einer Position eines Targets (128) in einen Erfassungsbereich (126) abhängt; und
   - der Referenz-Schwingkreis so ausgebildet ist, dass der Schwingungsparameter für den Referenz-Schwingkreis im Wesentlichen unabhängig ist von der Position des Targets (128) im Erfassungsbereich (126).

2. Induktiver Näherungsschalter gemäß Anspruch 1,
   **dadurch gekennzeichnet, dass**
   der Signal-Schwingkreis eine Signalspule (102) umfasst und der Referenz-Schwingkreis eine Referenzspule (104) umfasst; wobei insbesondere die Signalspule (102) und die Referenzspule (104) mit im Wesentlichen gleicher Induktivität ausgebildet sind; und wobei insbesondere die Signalspule (102) und die Referenzspule (104) als Luftspulen ohne Ferritkern ausgebildet sind.

3. Induktiver Näherungsschalter gemäß einem der vorhergehenden Ansprüche,
   **dadurch gekennzeichnet, dass**
   die Multiplexer-Schaltung (106) dazu eingerichtet ist, zum Aktivieren des Signal-Schwingkreises eine Verbindung leitend zu schalten, so dass ein Kondensator (130) und die Signalspule (102) den Signal-Schwingkreis bilden, und zum Aktivieren des Referenz-Schwingkreises eine Verbindung leitend zu schalten, so dass der Kondensator (130) und die Referenz-Spule (104) den Referenz-Schwingkreis bilden.

4. Induktiver Näherungsschalter gemäß einem der vorhergehenden Ansprüche,
   **dadurch gekennzeichnet, dass**
   die Signalspule (102) als zylindrisch gewickelte Spule ausgebildet ist, insbesondere als Planarspule.

5. Induktiver Näherungsschalter gemäß einem der vorhergehenden Ansprüche,

**dadurch gekennzeichnet, dass**
die Referenzspule (104) eine Mehrzahl von Teil-Wicklungen (Q1, Q2, Q3, Q4) aufweist, insbesondere vier Teil-Wicklungen (Q1, Q2, Q3, Q4) oder ganzzahlige Vielfache von vier Teil-Wicklungen (Q1, Q2, Q3, Q4), wobei die Teil-Wicklungen (Q1, Q2, Q3, Q4) zueinander gegenläufig ausgebildet sind; wobei die Referenzspule (104) insbesondere als Planarspule ausgebildet ist; wobei insbesondere die gegenläufigen Teil-Wicklungen (Q1, Q2, Q3, Q4) so ausgebildet und/oder angeordnet sind, dass sich die von den Teil-Wicklungen (Q1, Q2, Q3, Q4) erzeugbaren Hochfrequenzfelder, insbesondere die induzierten Magnetfelder, bei aktiviertem Referenz-Schwingkreis im Wesentlichen auslöschen.

6. Induktiver Näherungsschalter gemäß einem der vorhergehenden Ansprüche,
**dadurch gekennzeichnet, dass**
das Auswertungsmodul (118) dazu eingerichtet ist, das Differenzsignal zu bestimmen, indem anhand einer Anzahl von Schwingungen innerhalb einer Torzeit bei aktivierter Signalspule (102) und Referenzspule (104) eine Differenz gebildet wird; was insbesondere einem Bestimmen der Differenz der Frequenzen von Signal- und Referenzspule entspricht.

7. Induktiver Näherungsschalter gemäß einem der vorhergehenden Ansprüche, **dadurch gekennzeichnet, dass**
die Signalspule (102) und die Referenzspule (104) flach ausgebildet und in Lagen übereinander angeordnet sind.

8. Induktiver Näherungsschalter gemäß Anspruch 7,
**dadurch gekennzeichnet, dass**

zumindest eine Gitterschicht (200, 500) mit der Signalspule (102) und der Referenzspule (104) übereinander angeordnet ist; wobei insbesondere die Gitterschicht (200, 500) für eine Abschirmung im Sinne der elektromagnetischen Verträglichkeit des induktiven Näherungsschalters (100) eingerichtet ist; wobei insbesondere eine erste Gitterschicht (200) oberhalb der Signalspule (102) und der Referenzspule (104) angeordnet ist und eine zweite Gitterschicht (500) unterhalb der Signalspule (102) und der Referenzspule (104) angeordnet ist.

9. Induktiver Näherungsschalter gemäß einem der vorhergehenden Ansprüche,
**dadurch gekennzeichnet, dass**
der Schwingungsparameter eine Frequenz und/oder Amplitude des aktivierten Schwingkreises betrifft.

10. Verfahren zum Betreiben eines induktiven Näherungsschalters (100) mit einem Signal-Schwingkreis und einem Referenz-Schwingkreis, wobei

◦ ein Signal-Schwingkreis und ein Referenz-Schwingkreis wechselweise aktiviert werden;
◦ ein Schwingungsparameter für den Signal-Schwingkreis und für den Referenz-Schwingkreis erfasst wird; und
◦ anhand der erfassten Werte des Schwingungsparameters ein Differenzsignal bestimmt wird; wobei
◦ der Signal-Schwingkreis so ausgebildet ist, dass der Schwingungsparameter von einer Position eines Targets (128) in einen Erfassungsbereich (126) abhängt; und
◦ der Referenz-Schwingkreis so ausgebildet ist, dass der Schwingungsparameter im Wesentlichen unabhängig ist von der Position des Targets (128) im Erfassungsbereich (126).

128

126

102 104

108

110

114 116 112

100

120

122

124

118

106

130

Fig. 1A

EP 4 439 982 A1

10

20

30

40

Fig. 1B

Fig. 2

Fig. 3A

Fig. 3B

Fig. 4A

Fig. 4B

Fig. 5

Fig. 6A

Fig. 6B

$$\left[ n \cdot \frac{d}{38} \right]$$

$n=5$

$\frac{d}{15}$

710

$I_S$

d

Fig. 7A

720

$n=5$

750

730

740

$I_S$

Fig. 7B

Fig. 8

Europäisches
Patentamt

European
Patent Office

Office européen
des brevets

**EUROPÄISCHER RECHERCHENBERICHT**

**Nummer der Anmeldung**

EP 24 16 5743

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2009/021248 A1 (BERNARD JACQUES [FR] ET AL) 22. Januar 2009 (2009-01-22)<br>* Absatz [0023] - Absatz [0033] *<br>* Abbildung 2 *<br>* Absatz [0004] - Absatz [0017] *<br>- - - - - | 1-10 | INV.<br>H03K17/95 |

**RECHERCHIERTE SACHGEBIETE (IPC)**

H03K

Der vorliegende Recherchenbericht wurde für alle Patentansprüche erstellt

| Recherchenort | Abschlußdatum der Recherche | Prüfer |
|---|---|---|
| Den Haag | 19. Juli 2024 | Simon, Volker |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    .........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 16 5743

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-07-2024

| Im Recherchenbericht angeführtes Patentdokument | Datum der Veröffentlichung | Mitglied(er) der Patentfamilie | Datum der Veröffentlichung |
|---|---|---|---|
| US 2009021248 A1 | 22-01-2009 | CN 101387709 A | 18-03-2009 |
| | | EP 2017652 A1 | 21-01-2009 |
| | | FR 2919072 A1 | 23-01-2009 |
| | | US 2009021248 A1 | 22-01-2009 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005001692 A1
- DE 3527650 A1
- DE 102017128472 A1
- DE 102013202573 B3
- US 20100225332 A1